# EUROPEAN PATENT APPLICATION

(11) **EP 1 696 050 A2**
(43) Date of publication of application: **30.08.2006**
(21) Application number: 06251041.7
(22) Date of filing: 27.02.2006
(51) Int. Cl.: C23C 16/04, C23C 16/458, F27D 5/00

(54) **Annular furnace spacers and method of using same**

(30) Priority: 25.02.2005 US 656082 P; 15.03.2005 US 661502 P; 15.02.2006 US 354083 P
(71) Applicant: Honeywell International, Inc., Morristown, New Jersey 07962 (US)
(72) Inventor: Arico, Alan A., South Bend IN 46614 (US); Johnson, Darrell L., South Bend IN 46614 (US); Parker, David E., Granger IN 46530 (US); Waghray, Akshay, Granger IN 46530 (US)
(74) Representative: Haley, Stephen

(57) **Abstract**

A furnace spacer (10, 30, 50, 70) for spacing a first annular prefonn (22) from a second annular preform (22) in a furnace (100), each of the first and second annular preforms (22) having an outer periphery and a width and an inner opening having a periphery and a width, the spacer (10, 30, 50, 70) having an annular body (12, 32, 52, 72) having an inner diameter and an outer diameter. Also a method of alternately stacking spacers and preforms in a furnace.

## Description

The present application claims the benefit of U.S. Provisional Application No. 60/656,082, filed February 25, 2005, and U.S. Provisional Application No. 60/661,502 filed March 15, 2005. The entire contents of both applications are hereby incorporated by reference.

The present invention is directed to a spacer for separating adjacent annular preforms in a furnace, and, more specifically, toward an annular spacer comprising a heatsink spacing one preform from another during a chemical vapor infiltration/deposition (CVI/CVD) process in a furnace.

Carbon-carbon and/or ceramic matrix composite disks may be used as brake rotors and/or stators in automotive and aircraft brake systems. During the manufacture of these discs, non-woven fiber preforms may be placed in a furnace and subjected to multiple CVI/CVD process cycles. During these processes, multiconstituent hydrocarbons and/or other precursor process gases are deposited in the body of the preforms as pyrocarbon or other ceramic matrices. This processing is referred to as densification and results in an increase in the density of the preform with each process cycle. The process will be referred to as CVD. Before the first CVD process cycle, for example, the preforms may have a density of about 0.5 g/cc.

Normally, CVD processes are carried out on multiple composite preforms that have been arranged in stacks in a CVD furnace. The composite preform are generally annular or ring shaped and must be spaced from adjacent preforms to allow gasses to flow around and into the preforms. It has generally been considered desirable to use a plurality of separate spacer elements between each pair of preforms so as not to interfere with process gas flow around the preforms, and so as not to block gas flow into the preforms. These spacers, however, sometime leave indentations in the preforms that must be machined off. In some cases, the indentations are too deep to be removed completely, and preforms with such deep indentations must be discarded.

Furthermore, in a conventional CVD process, a density gradient may be observed in the densified discs - the outer and inner diameters tend to have the highest density while the center of the disk has a lower density. This is believed to occur because of diffusional limitations of gasses passing through the inner and outer periphery of the disks maintained at a constant temperature (isothermal process). To achieve the desired final density, all the surfaces of the disks need to be machined between multiple cycles.

It would therefore be desirable to provide a spacer that is easy to use, that does not leave unacceptably deep indentations in the preforms, and that does not interfere with the densification process in the furnace.

These problems and others are addressed by the present invention, which comprises, in a first aspect, a furnace spacer for spacing a first preform from a second preform. The first and second preforms each have an outer periphery, a width, an inner opening having a periphery and a width, a first side having an area and a second side spaced from the first side. The spacer has a body with an inner opening and an outer periphery, and an area bounded by the spacer outer periphery and the spacer inner opening is greater than about thirty percent of the area of the preform first side.

Another aspect of the invention comprises a stack formed from a plurality of preforms and spacers stacked for treatment in a furnace. Each preform is a disk having a center opening having a width and having an outer periphery and each spacer comprises a ring. One of the plurality of spacers is provided between an adjacent pair of the plurality of preforms.

A further aspect of the invention comprises a method of spacing a first preform from a second preform in a furnace that involves providing first and second annular preforms each having a center opening having a width and an exterior periphery and placing the first annular preform on a support. The method further comprises providing a first annular spacer, placing the first spacer on the first annular preform, placing the second annular preform on the first spacer, and placing the first and second annular preforms and the first spacer into a furnace.

### In the Drawings;

These and other aspects of the invention will be better understood after a reading of the detailed description provided below together with the following drawings, wherein:

Figure 1 is a perspective view of a spacer according to a first embodiment of the present invention;

Figure 2 is a perspective view of a spacer according to a second embodiment of the present invention;

Figure 3 is a perspective view of a spacer according to a third embodiment of the present invention;

Figure 4 is a perspective view of a spacer according to a fourth embodiment of the present invention;

Figure 5 is a plan view of the spacer of Figure 1 supported by a preform; and

Figure 6 is an elevational view showing a plurality of preforms and spacers stacked in a furnace.

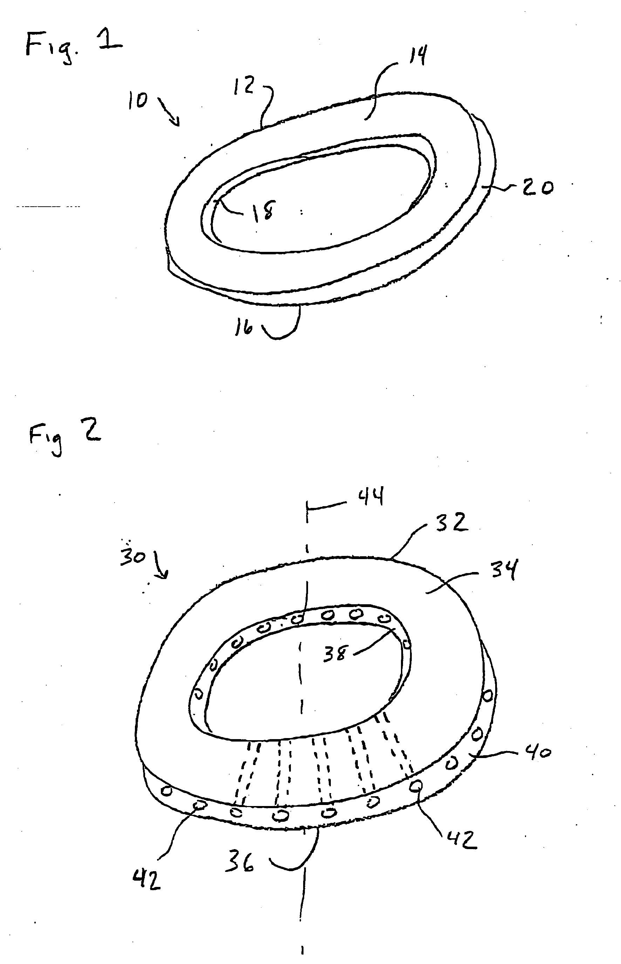

Referring now to the drawings, wherein the showings are for the purpose of illustrating preferred embodiments of the invention only and not for the purpose of limiting same, Figure 1 illustrates a spacer 10 according to a first embodiment of the present invention which comprises an annular body 12 having a first planar side 14, a second planar side 16 parallel to first planar side 14 and an inner peripheral wall 18 and an outer peripheral wall 20 connecting the first and second planar sides 14, 16. Body 12 in this embodiment is formed from graphite or carbon-carbon composites. In this embodiment, body 12 is about one-half inch thick, but may be somewhat thicker or thinner depending on the preforms with which it is used.

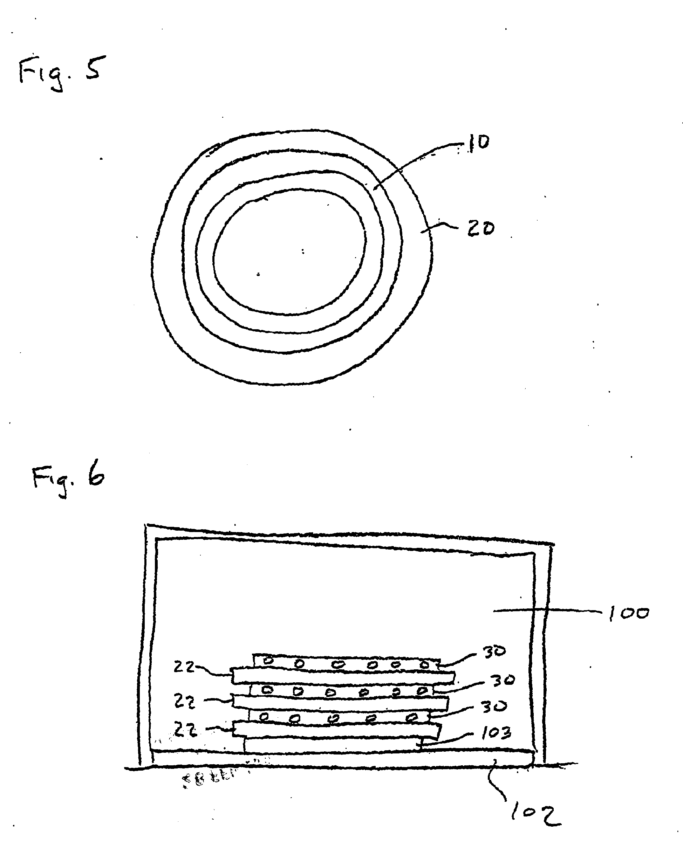

The size of the spacer is selected to have a surface area between about 30 and 70 percent the surface area of the preform with which it will be used and, more preferably, to have a surface area between about 35 and 50 percent the surface area of the preform with which it will be used. As used herein, the area or surface area of a side of a spacer will refer to the area of a plane bounded by the outer periphery of the spacer and the inner opening of the spacer without regard to surface irregularities or openings in the spacer. Thus, for example, two annular spacers having equal inner diameters and equal outer diameters will have the same surface area on a side even if the side of one spacer includes a plurality of openings as illustrated, for example, in Figure 3.

The use of such large surface area spacers provides good support for the preforms and minimizes or substantially eliminates the indentations caused by smaller and/or discrete spacers. However, it had previously been thought that the use of a solid spacer such as the ones disclosed herein would have interfered significantly with gas flow and would have prevented satisfactory densification. Surprisingly, however, the present inventors have found that the mass of such large spacers serves as a heat sink and absorbs radiant heat from the CVD furnace wall which is either heated using resistance heating elements or induction coils.

The mass of the spacer sets up a thermal gradient in the preform because the spacer picks up radiant heat and keeps the center of the annular disks hot while the gas that is admitted to the furnace at ambient conditions cools the inner and outer diameters of the disks. The gas diffusing through the porous preform from the inner and outer diameters deposits carbon faster in the center, which is at a higher temperature, and slower at the inner and outer regions, which are at lower temperatures. This results in an efficient and more uniform densification of the disks. The efficiency is realized by achieving a higher final density in fewer cycles. Thus, while the spacer of this embodiment of the invention covers a greater portion of the surface area of a preform than previously used spacers and interferes with gas circulation to a greater extent than previous spacers, these problems are more than overcome by 1) the reduced incidence of indentations in the preforms and 2) the more effective densification that occurs when heat from the heatsink / spacers is provided to the preforms, especially the central portions thereof. To function adequately as a heat sink, the spacer should generally have a density at least about three times the density of the preform before densification begins.

The spacer of this embodiment has been described as "annular," and will be generally be used with annular preforms. However, it is not critical that the inner and outer walls be perfectly round - this will depend on the manufacturing process for the spacers. Thus, as used herein, the term "annular" is intended to cover both spacers with circular inner and outer peripheries as well as spacers that are not quite circular and/or that include one or more flattened side portions on the inner or outer peripheries.

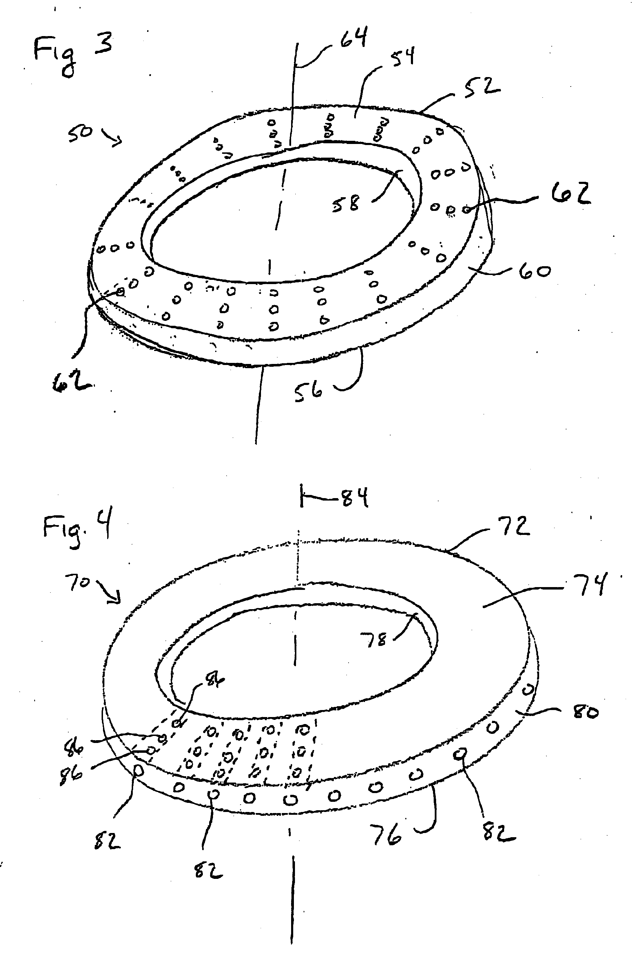

A second embodiment of the invention is illustrated in Figure 2. The spacer 30 of Figure 2 includes an annular body 32 having a first planar side 34, a second planar side 36 parallel to first planar side 34, an inner peripheral wall 38 and an outer peripheral wall 40 connecting the first and second planar sides 34, 36. Spacer 30 also includes a plurality of through openings 42 extending from inner peripheral wall 38 to outer peripheral wall 40. Spacer 30 surrounds an axial centerline 44, and in this embodiment, openings 42 are radially disposed with respect to centerline 44; however, openings similar to openings 42 but angled with respect to centerline 44 and not radially disposed could also be used. This embodiment provides the support and heatsink benefits discussed above in connection with the first embodiment, while through openings 42 contribute to improved gas circulation, especially radially gas flow, in a furnace when a plurality of spacers 30 and preforms are stacked.

A third embodiment of the invention is illustrated in Figure 3. Spacer 50 includes an annular body 52 having a first planar side 54, a second planar side 56 parallel to first planar side 54, an inner peripheral wall 58 and an outer peripheral wall 60 connecting the first and second planar sides 54, 56. Spacer 50 also includes a plurality of through openings 62 extending from first planar side 54 to second planar side 56. Spacer 50 surrounds an axial centerline 64, and in this embodiment, openings 62 are parallel to axial centerline 64; however, openings similar to openings 62 but angled with respect to centerline 64 and could also be used. This embodiment provides the support and heatsink benefits discussed above in connection with the first embodiment, while through openings 62 contribute to improved gas circulation between adjacent preforms in a stack when a plurality of spacers 50 and preforms are stacked in a furnace.

A fourth embodiment of the invention is illustrated in Figure 4. Spacer 70 in this figure includes an annular body 72 having a first planar side 74, a second planar side 76 parallel to first planar side 74 and an inner peripheral wall 78 and an outer peripheral wall 80 connecting the first and second planar sides 74, 76. Spacer 70 also includes a plurality of through openings 82 extending from inner peripheral wall 78 to outer peripheral wall 80. Spacer 70 surrounds an axial centerline 84, and in this embodiment, openings 82 are radially disposed with respect to centerline 84; however, openings similar to openings 82 but angled with respect to centerline 84 and not radially disposed could also be used. Spacer 70 also includes openings 86 connecting first planar side 74 and second planar side 76 and intersecting radial openings 82. This embodiment allows for gas flow both from the inside to the outside of the spacers and to and between preforms above and below a given spacer in a stack.

Figure 6 illustrates a CVD furnace 100 that includes a floor 102 on which a support, such as a settler plate 103, for supporting a stack of preforms is placed. The "floor" of the furnace illustrated in Figure 6 may be part of a support hearth plate used for premixing and preheating the process gases. The process gases may be introduced through perforations in this "floor" that are located inside and outside the annulus of the stack. A first preform 22 is supported by settler plate 103, a spacer 30 is placed on top of the preform 22, and additional preforms 22 and spacers 30 are alternately stacked on the first preform 22. The thickness of preforms 22 will generally vary from somewhat less than one inch to around two inches, depending on the intended use of the finished disk, with a common thickness being around one and one half inches. While a spacer 30 of the second embodiment is illustrated, a spacer according to any of the foregoing embodiments could be used. A perforated lid (not shown) or an additional spacer may be placed at the top of the stack at the top of the furnace in a manner known to those of ordinary skill in this field. Moreover, process gases should be introduced into the furnace in a conventional manner, bearing in mind that it may be desirable to keep the residence times of the gas introduced into the interior of the stack and the gas introduced into the furnace surrounding the stack generally equal. The stack may be formed in the furnace or formed outside the furnace and moved into the furnace for processing, in a well known manner. After processing, the preforms and spacers are removed from the furnace 100, and the preforms and spacers are separated.

The present invention has been described herein in terms of several preferred embodiments. However, various additions and modifications to the embodiments will become apparent to those skilled in the relevant arts upon a reading of the foregoing disclosure. It is intended that all such obvious additions and modifications form a part of the present invention to the extent they fall within the scope of the several claims appended hereto.

## Claims

1. A furnace spacer (10, 30, 50, 70) for spacing a first preform (22) from a second preform (22), the first and second preforms (22) each having an outer periphery, a width, an inner opening having a periphery and a width, a first side (14, 34, 54, 74) having an area and a second side (16, 36, 56, 76) spaced from said first side (14) and having an area, said spacer (10, 30, 50, 70) comprising a body (12, 32, 52, 72) having an inner opening having a width and an outer periphery having a width, wherein an area bounded by said spacer outer periphery and said spacer inner opening is greater than about 30 percent of said preform first side area, preferably from about 30 to 70 percent of the spacer first side area, and more preferably, from about 35 to 50 percent of the spacer first side area.

2. The furnace spacer (10, 30, 50, 70) of claim 1 wherein said spacer first (14, 34, 54, 74) and second (16, 36, 56, 76) sides are parallel and planar.

3. The furnace spacer (10, 30, 50, 70) of claim 1 wherein said body (12, 32, 52, 72) is formed of graphite.

4. The furnace spacer (50, 70) of claim 2 wherein said spacer (50, 70) includes a plurality of openings (62, 86) between said first (54, 74) and second (56, 76) parallel sides.

5. The furnace spacer (30, 70) of claim 2 wherein said spacer (30, 70) includes an inner peripheral wall (38, 78) bounding said inner opening and an outer wall (40, 80) defining said spacer width and a plurality of openings (42, 82) connecting said inner wall (38, 78) and said outer wall (40, 80).

6. The furnace spacer (50, 70) of claim 4 wherein said spacer (50, 70) includes an inner peripheral wall (38, 78) bounding said inner opening and an outer wall (40, 80) defining said spacer width and a plurality of openings (42, 82) connecting said inner wall (38, 78) and said outer wall (40, 80).

7. The furnace spacer (10, 30, 50, 70) of claim 1 wherein the preforms (22) have a first density and said spacers (10, 30, 50, 70) have a second density at least three times greater than said first density.

8. A stack comprising a plurality of preforms (22) and spacers (10, 30, 50, 70) stacked for treatment in a furnace (100),
each preform (22) comprising a disk having a center opening having a width and having an outer periphery; and
each spacer (10, 30, 50, 70) comprising a ring;
wherein one of the plurality of spacers (10, 30, 50, 70) is provided between an adjacent pair of said plurality of preforms (22).

9. The stack of claim 8 wherein said spacer (10, 30, 50, 70) comprises a ring having first (14, 34, 54, 74) and second (16, 36, 56, 76) parallel surfaces, the surface area of said ring first surface being from about 30 to 70 percent the surface area of one side of the preform (22) and more preferably from about 35 to 50 percent the surface area of one side of the preform (22).

10. A method of spacing a first preform from a second preform in a furnace comprising the steps of:
providing first and second annular preforms each having a center opening having a width and an exterior periphery;
placing the first annular preform on a support;
providing a first annular spacer;
placing the first spacer on the first annular preform;
placing the second annular preform on the first spacer; and
placing the first and second annular preforms and the first spacer into a furnace.
